# EUROPEAN PATENT APPLICATION

(11) **EP 1 120 832 A1**
(43) Date of publication of application: **01.08.2001**
(21) Application number: 99926920.2
(22) Date of filing: 02.07.1999
(51) Int. Cl.: H01L 27/14, H04N 5/335

(54) **SOLID STATE IMAGE SENSING DEVICE AND PRODUCTION METHOD THEREOF**

(71) Applicant: MATSUSHITA ELECTRIC INDUSTRIAL CO., LTD., Kadoma-shi, Osaka 571-8501 (JP)
(72) Inventor: Kuriyama, Toshihiro, Otsu-shi, Shiga 520-2134 (JP); Matsuda, Yuji, Takatsuki-shi, Osaka 569-0853 (JP); Uchida, Shinji, Round-City-Fudoukouriminami, Neyagawa-shi, Osaka 572-0807 (JP)
(74) Representative: Jeffrey, Philip Michael
(86) International application number: JP9903601
(87) International publication number: WO0103192

(57) **Abstract**

An anti-reflection film (25) formed of an oxide having a refractive index of at least 1.9 is formed above light-receiving portions (22) that are formed in a semiconductor substrate (21) of a solid-state imaging device. The oxide can be a metal oxide of such as titanium, zirconium, tantalum, indium or niobium.

## Description

### Technical Field

The present invention relates to a solid-state imaging device, and more particularly to a highly sensitive solid-state imaging device that outputs images with an excellent quality and a method for manufacturing the same.

### Background Art

Currently, it is common to provide solid-state imaging devices with CCDs (charge-coupled devices) for reading out a signal charge. In order to increase resolution and reduce sizes of optical systems, solid-state imaging devices with more pixels and a smaller size have been developed, causing a problem in that sensitivity needs to be improved. The solid-state imaging device has the following structure. Photodiodes are formed as light-receiving portions in a semiconductor substrate. Transfer electrodes are formed on this semiconductor substrate via an insulating film. Then, an interlayer insulating film, a shielding film having an opening above the light-receiving portions and a surface protection film are laminated thereon in this order. In such solid-state imaging devices, light enters through the opening of the shielding film and is converted into an electrical charge by the photodiode so as to be accumulated as a signal charge. This signal charge is read out by the CCD and transferred to an output amplifier.

In such solid-state imaging devices, there is a difference in refractive index between the silicon oxide film used as the insulating film and the silicon forming the substrate. Because of this difference, incident light is reflected by the substrate surface. Consequently, less light reaches the photodiodes, thus lowering the sensitivity. In order to solve this problem, it has been suggested that an anti-reflection film formed of silicon nitride film be provided between the substrate and the interlayer insulating film so as to produce a multiple interference effect, thereby reducing the loss of incident light and improving the sensitivity (JP 63-14466 A and JP 4-152674 A).

In addition, in such solid-state imaging devices, even when light does not enter the photodiodes, a thermally generated charge, a so-called dark current, is accumulated. The dark current is mixed with the signal charge corresponding to the incident light, so as to interrupt the transmission of a signal corresponding to an incident image accurately, thus causing roughness in an output image. It is known that this dark current can be reduced by supplying hydrogen to the substrate surface. The hydrogen is supplied using hydrogen that is generated when forming the silicon nitride film as the surface protection layer. Alternatively, the hydrogen is supplied more reliably by heat-treating the substrate in a hydrogen atmosphere during a manufacturing step of the solid-state imaging device (JP 60-66826 A).

However, the silicon nitride film used as the anti-reflection film in the conventional solid-state imaging devices has a fine crystal structure, causing the following problems. That is, since hydrogen cannot permeate through the silicon nitride film easily, the hydrogen supply to the substrate that is necessary for reducing the dark current is interrupted, making it difficult to improve image quality sufficiently. Also, since the silicon nitride film has a large internal stress, stress concentrates in a stepped portion or the like, causing the problem in that "a white mark," which is a defect in the image quality, is generated easily.

### Disclosure of Invention

It is an object of the present invention to solve the conventional problems described above and to provide a highly sensitive solid-state imaging device that outputs images with an excellent quality and a method for manufacturing the same.

In order to achieve the above-described object, the solid-state imaging device of the present invention includes a semiconductor substrate, light-receiving portions formed in this semiconductor substrate, and an anti-reflection film formed above this light-receiving portions. This anti-reflection film is formed of an oxide having a refractive index of at least 1.9.

Since the anti-reflection film is formed of a material having a smaller internal stress than the conventionally used silicon nitride film, there is a smaller stress that is generated in the film to concentrate in the stepped portion. Thus, the defects in the image quality such as a white mark can be reduced. Also, an excellent hydrogen permeability allows a sufficient hydrogen supply to the substrate, which is necessary for reducing the dark current. Moreover, a high refractive index can produce an anti-reflection effect so as to improve the sensitivity.

In addition, although there was a limitation in the shape of the anti-reflection film in order to maintain hydrogen permeability when using the silicon nitride film as the anti-reflection film, the present invention does not need such limitation. Accordingly, the present invention has an advantage in that various designs of the anti-reflection film shapes are possible, thereby further increasing the sensitivity and simplifying the manufacturing process.

In the above solid-state imaging device, it is preferable that the anti-reflection film is formed of the oxide of at least one metal selected from the group consisting of titanium, zirconium, tantalum, indium and niobium. Also, a preferable thickness of the anti-reflection film is at least 10 nm and not larger than 70 nm. With such structures of the anti-reflection film, it is possible to achieve higher sensitivity of the solid-state imaging device while maintaining the quality of the output images. It is preferable that the anti-reflection film has a refractive index of at least 2.1, and it is particularly preferable that the anti-reflection film has a refractive index of at least 2.3.

Also, it is preferable that the above solid-state imaging device further includes electrodes for transferring a charge accumulated in the light-receiving portions, a shielding film formed above the electrodes so that an opening is provided above the light-receiving portions, and an interlayer insulating film interposed between the electrodes and the shielding film. This interlayer insulating film is formed on the anti-reflection film above the light-receiving portions and has a lower refractive index than the anti-reflection film. Also, it is preferable that the interlayer insulating film has a thickness of at least 30 nm and not larger than 600 nm, and it is particularly preferable that the interlayer insulating film has a thickness of at least 30 nm and not larger than 100 nm. With these preferable examples, it is possible to achieve still higher sensitivity of the solid-state imaging device.

Furthermore, it is preferable that the above solid-state imaging device further includes a surface protection film formed on the interlayer insulating film. The surface protection film has a higher refractive index than the interlayer insulating film. It is preferable that this surface protection film has a thickness of at least 100 nm and not larger than 300 nm, and it is particularly preferable that the surface protection film has a thickness of at least 100 nm and not larger than 180 nm. Also, it is preferable that the above solid-state imaging device further includes a silicon oxide film that is interposed between the semiconductor substrate and the anti-reflection film. These structures are advantageous in that still higher sensitivity of the solid-state imaging device can be achieved as described above.

Moreover, in the above solid-state imaging device, it is preferable that the anti-reflection film is formed so as to cover entirely at least a region where the light-receiving portions are formed, and it is further preferable that the anti-reflection film is formed so as to cover at least a part of a region where electrodes are formed. With these preferable examples, it is possible to obtain more reliable anti-reflection effects. By forming the anti-reflection film after the electrode as described above, it becomes possible to prevent the anti-reflection film from serving as a pollution source of the electrode, thereby achieving a solid-state imaging device with an excellent quality.

In addition, in order to achieve the above-described object, a method for manufacturing the solid-state imaging device of the present invention includes forming light-receiving portions in a semiconductor substrate, and forming an anti-reflection film above the light-receiving portions. The anti-reflection film is formed of an oxide having a refractive index of at least 1.9.

### Brief Description of Drawings

FIG. 1 is a plan view showing an example of a structure of a solid-state imaging device of the present invention.
FIG. 2 is a sectional view taken along the line X-X' in FIG. 1.
FIG. 3 is a sectional view taken along the line Y-Y' in FIG. 1.
FIG. 4 is a plan view showing another example of the structure of the solid-state imaging device of the present invention.
FIG. 5 is a sectional view taken along the line X-X' in FIG. 4.
FIG. 6 is a sectional view taken along the line Y-Y' in FIG. 4.
FIG. 7 shows a result of measuring the light reflectance in a solid-state imaging device produced in a first example.
FIG. 8 shows a result of measuring the light reflectance in a conventional solid-state imaging device.
FIG. 9 shows a result of measuring the light reflectance in a solid-state imaging device produced in a second example.
FIG. 10 shows a result of measuring the light reflectance in another solid-state imaging device produced in the second example.

### Best Mode for Carrying Out the Invention

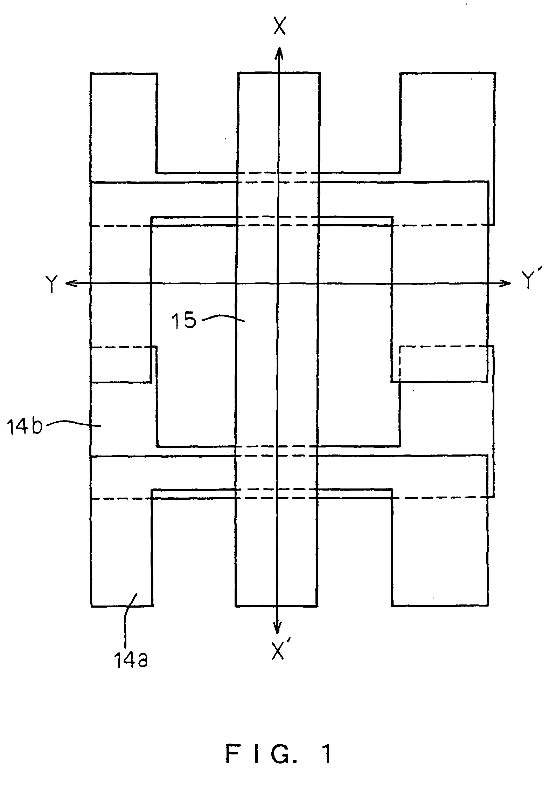

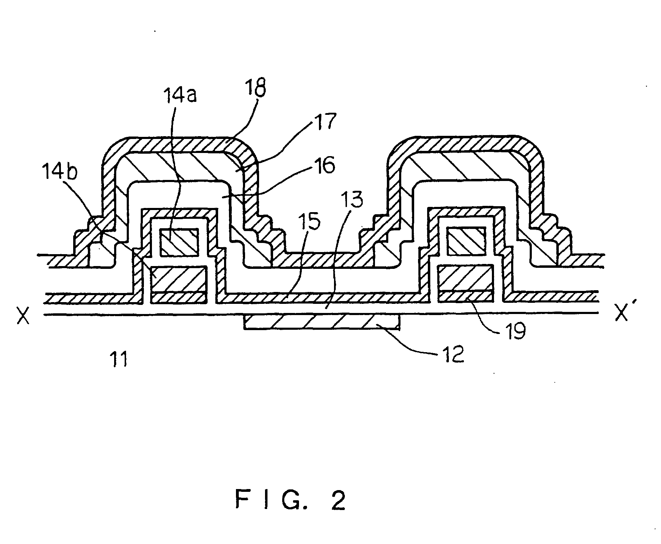

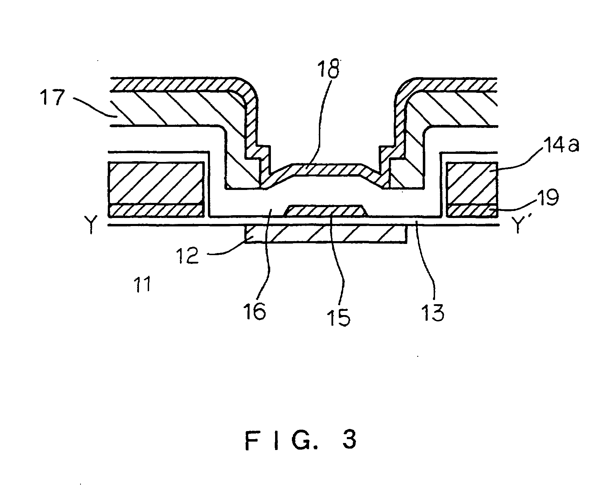

First, the following is a description of the structure of a solid-state imaging device of the present invention, with reference to FIGs. 1 to 3. FIG. 1 is a plan view, FIG. 2 is a sectional view taken along the line X-X' in FIG. 1, and FIG. 3 is a sectional view taken along the line Y-Y' in FIG. 1. In FIG. 1, upper structures such as a shielding film 17 are omitted. Light-receiving portions 12, which are photodiodes, are formed in a semiconductor substrate 11. These light-receiving portions 12 are arranged in the substrate surface in a two-dimensional manner so that columnar arrays of a plurality of the light-receiving portions and CCD portions, which are not shown in the drawing, are placed alternately. On this substrate 11, comb-shaped transfer electrodes 14a and 14b as shown in FIG. 1 are formed via an insulating layer 13 so as not to cover the light-receiving portions 12, and an interlayer insulating film 16 further is formed. For the purpose of preventing light from entering a region other than the light-receiving portions such as the CCD portion, the metal shielding film 17 is formed thereon. In order to allow light to enter the light-receiving portions, this metal shielding film is provided with an opening in the portion above the light-receiving portions. Furthermore, a surface protection film 18 is formed thereon. The members described above can be formed using conventionally used materials and methods.

Furthermore, in the solid-state imaging device of the present invention, an anti-reflection film 15 is formed between the light-receiving portions and the interlayer insulating film in the region where the light-receiving portions 12 are formed. This anti-reflection film considerably reduces the incident light reflection that has occurred on the substrate surface, thus improving the sensitivity behavior.

The anti-reflection film 15 is formed of metal oxide that has a sufficient hydrogen permeability and a refractive index of at least 1.9, for example, at least 1.9 and not larger than 2.7. The metal oxide can be, for example, titanium oxide (refractive index of 2.2 to 2.7; the refractive index will be put in parentheses in the following), zirconium oxide (2.0 to 2.1), tantalum oxide (1.9 to 2.2), indium oxide (1.9 to 2.1) or niobium oxide (2.1 to 2.3). Since oxide films thereof have an excellent hydrogen permeability, the above-described dark current can be reduced effectively. In addition, since these oxide films have a smaller internal stress than a silicon nitride film, it is possible to reduce white marks that appear in an output image.

In particular, a titanium oxide film (refractive index of 2.2 to 2.7) has a sufficiently higher refractive index than silicon nitride film (refractive index of 2.0), thus achieving anti-reflection effects more reliably. In addition, the titanium oxide has a higher refractive index in a short-wavelength range (for example, 400 nm) in a visible light region than in a long-wavelength range (for example, 700 nm). The refractive index of silicon has a similar distribution in the visible light region. Therefore, the use of the titanium oxide as the anti-reflection film can obtain an excellent anti-reflection effect in a wider wavelength range.

This anti-reflection film 15 may have a multilayer structure of a plurality of above-mentioned oxide films laminated. Also, as described above, it is preferable that the anti-reflection film is formed after the electrode, so as to prevent the material of the anti-reflection film from serving as a pollution source for the electrode.

Using the anti-reflection film described above, a preferable form of a multilayer interference film that is formed above the light-receiving portions includes the silicon oxide film with a thickness of 50 nm or smaller, the anti-reflection film with a thickness of at least 10 nm and not larger than 70 nm, the interlayer insulating film with a thickness of at least 30 nm and not larger than 600 nm, and the surface protection film with a thickness of at least 100 nm and not larger than 300 nm in this order from the side of the light-receiving portions. The interlayer insulating film is not specifically limited and, for example, can be silicon oxide film. It is preferable that the interlayer insulating film is formed of a material having a lower refractive index than the anti-reflection film and the surface protection film. Also, as the surface protection film, silicon nitride film, oxide films having a refractive index of at least 1.9 (for example, the various metal oxides preferable for the anti-reflection film as indicated above) or the like can be used.

It is preferable that the anti-reflection film is formed so as to cover the region completely where the light-receiving portions are formed and at least a part of the region where the electrodes are formed. By forming the anti-reflection film as above, the anti-reflection effect can be obtained also at the end of the light-receiving portions, thereby achieving higher sensitivity in a reliable manner. Also, with the size increase in the region where the anti-reflection film is formed, less exactness in margin setting is required and patterning of the anti-reflection film becomes easier or unnecessary. This is advantageous in designing the solid-state imaging device and in the manufacturing process thereof.

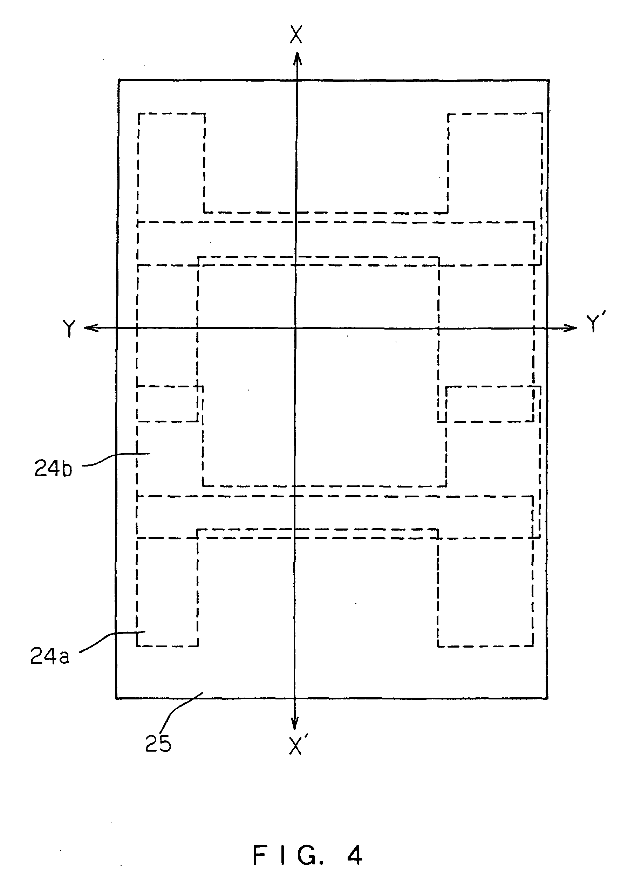

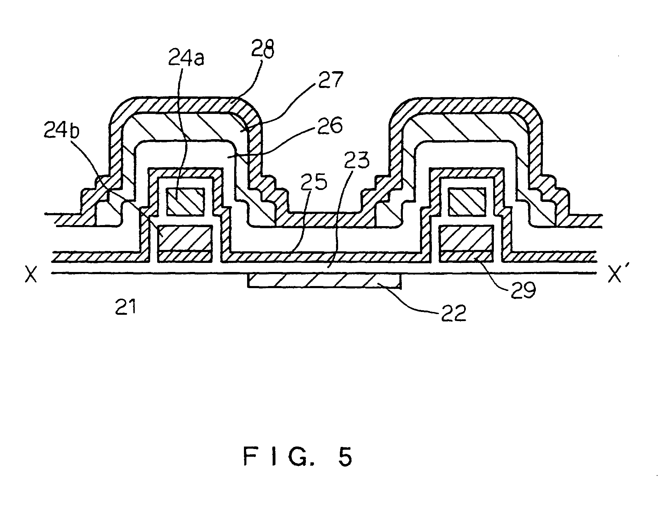

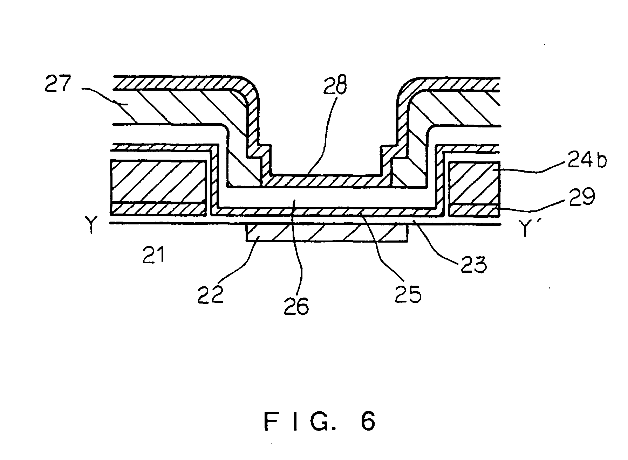

FIGs. 4 to 6 show an example of the solid-state imaging device of the present invention that has the anti-reflection film formed to have such a preferable shape. FIG. 4 is a plan view, FIG. 5 is a sectional view taken along the line X-X' in FIG. 4, and FIG. 6 is a sectional view taken along the line Y-Y' in FIG. 4. In FIG. 4, a shielding film 27 etc. is not shown in the drawings for simplicity. This preferable example is the same as the above-described embodiment (FIGs. 1 to 3) except for the shape of the anti-reflection film. A semiconductor substrate 21 in which light-receiving portions 22 are formed, an insulating film 23, transfer electrodes 24a and 24b, an anti-reflection film 25, an interlayer insulating film 26, a shielding film 27 and a surface protection film 28 are laminated. The material for forming the anti-reflection film 25 also is the same as that described above. In this preferable example, the anti-reflection film that has been grown by a conventional method is used without pattern formation. The anti-reflection film is formed on the substrate plane including the region where the electrodes and the light-receiving portions are formed, as shown in FIG. 4. With such a shape, it is possible to obtain a reliable anti-reflection effect because the region above the light-receiving portions is coated completely by the anti-reflection film. Also, since the patterning of the anti-reflection film is not necessary, this shape has an advantage in achieving a simpler manufacturing process.

### Example

The present invention will be described more specifically, with reference to the following examples. A solid-state imaging device described below has a structure similar to those shown in FIGs. 4 to 6 used for the description above.

### First Example

N-type impurities such as phosphorus were ion-implanted in a p-type silicon substrate 21, thereby forming photodiodes 22. On this substrate 21, an insulating film 23 formed of silicon oxide film with a thickness of 30 nm was grown by thermal oxidation. Next, a polysilicon film with a thickness of 300 nm was grown by CVD (chemical vapor deposition), so as to form electrodes 24a and 24b by dry etching. An insulating film 29 formed of silicon nitride film had been formed between these polysilicon electrodes 24a, 24b and the insulating film 23 formed of silicon oxide film. After coating the electrodes with the silicon oxide film 23 by thermal oxidation, an anti-reflection film 25 formed of titanium oxide film with a thickness of 20 nm was grown on an entire surface of the substrate by low pressure CVD. Next, a silicon oxide film was grown by low pressure CVD so as to form an interlayer insulating film 26 with a thickness of 90 nm, then a shielding film 27 with a thickness of 400 nm formed of aluminum was formed by sputtering, followed by dry etching to provide an opening in the shielding film 27 above the photodiodes 22. Furthermore, the entire substrate surface was coated with a surface protection film 28 formed of silicon nitride film with a thickness of 120 nm by plasma CVD. Subsequently, heat-treatment under a hydrogen atmosphere at 450°C was performed for 30 minutes so as to obtain a solid-state imaging device.

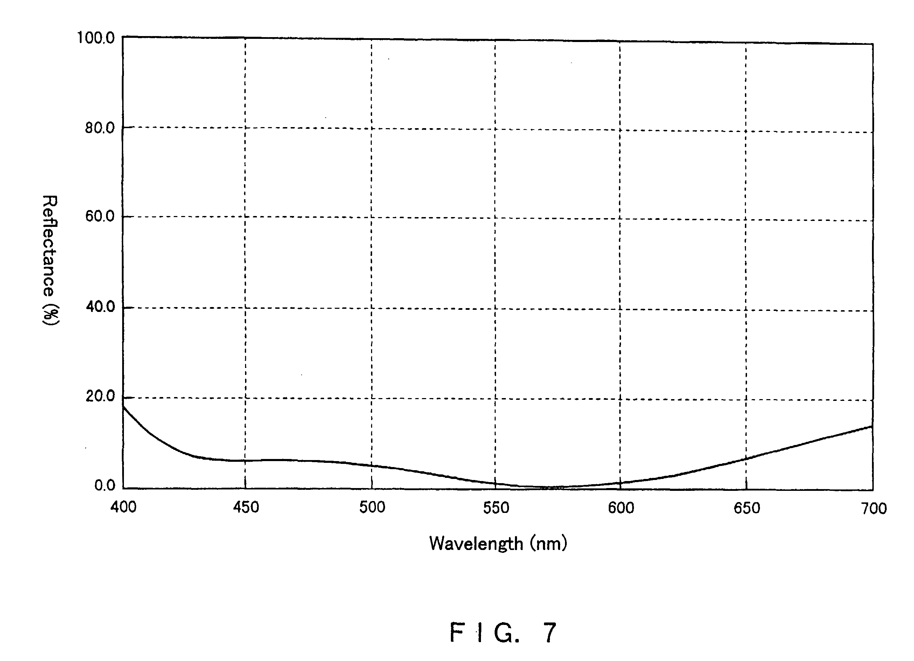

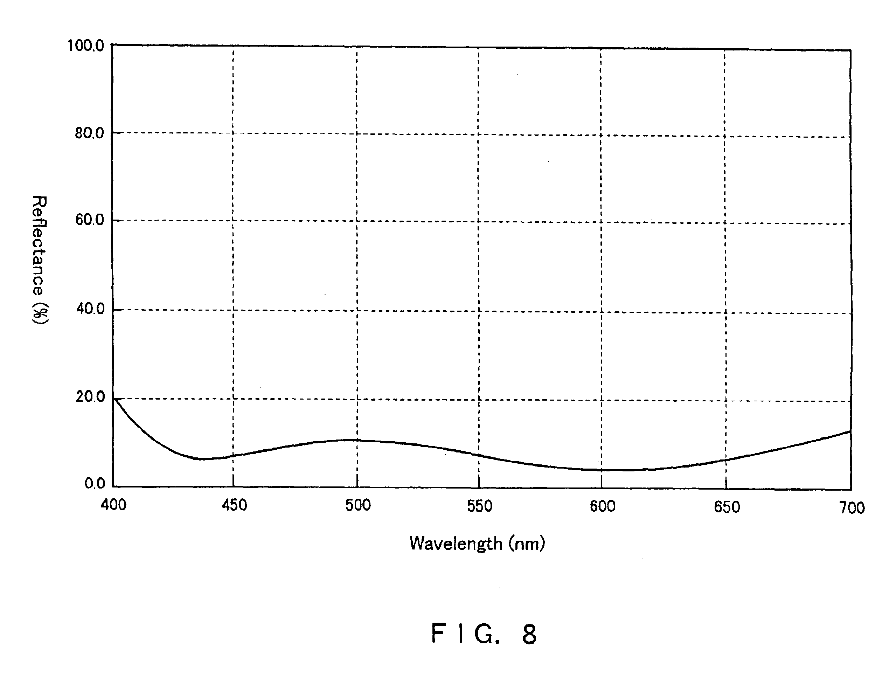

In the above solid-state imaging device, reflectance of light entering through the opening of the shielding film was measured, and the result of the measurement is shown in FIG. 7. On the other hand, FIG. 8 shows the result of measuring the reflectance in a solid-state imaging device produced similarly to the present example except that silicon nitride film was used as the anti-reflection film. By comparing FIG. 7 with FIG. 8, it was confirmed that the solid-state imaging device of the present example was able to reduce the reflected light more reliably at least in the wavelength range with a high visibility.

When dark current generated in the above solid-state imaging device was measured, it was 0.5 mV at the temperature of 60°C. On the other hand, in the case of using the silicon nitride film as the anti-reflection film, when dark current generated was measured under other conditions being equal, it was 1.0 mV. This confirmed that the solid-state imaging device of the present example was able to reduce the generated dark current by about half. In addition, in an output screen of an imaging apparatus using the conventional solid-state imaging device provided with the anti-reflection film formed of the silicon nitride film, white mark defects occurred in 10 pixels out of 400,000 pixels. On the other hand, no white mark defect was found in an imaging apparatus using the solid-state imaging device of the present example. Thus, it was confirmed that the solid-state imaging device of the present example was able to achieve better image quality than the conventional device.

### Second Example

A solid-state imaging device was obtained in a similar manner to the first example except that films above photodiodes had a structure as in the following table.

| | | |
|---|---|---|
| Film structure (material) | Refractive index | Film thickness (nm) |
| Surface protective film (silicon nitride film) | 2.0 | 111 |
| Layer insulating film (silicon oxide film) | 1.46 | 90 |
| Anti-reflection film (tantalum oxide film) | 2.1 | 35 |
| Silicon oxide film | 1.46 | 21 |

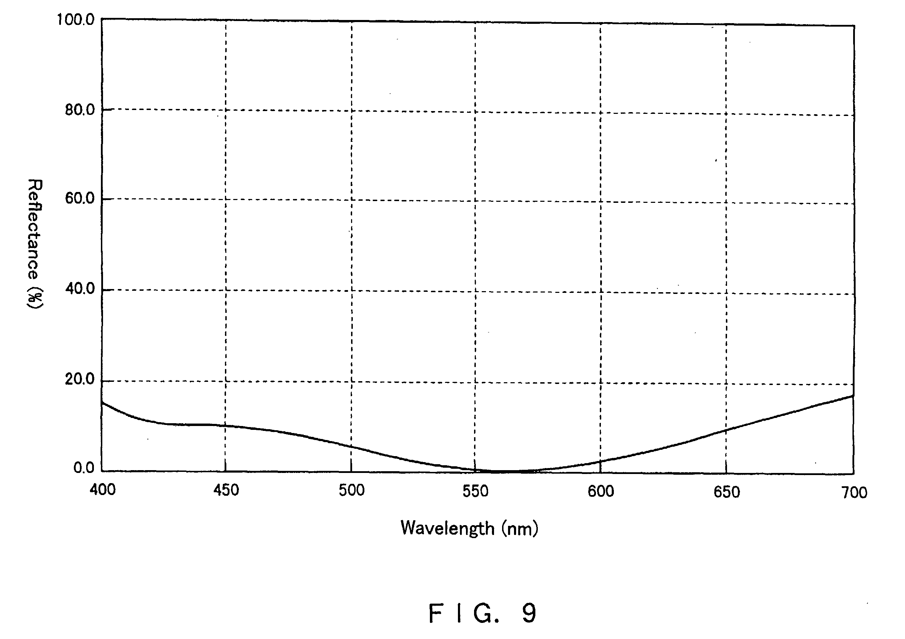

In this solid-state imaging device, spectral reflectance was measured in a similar manner to the first example. The result is shown in FIG. 9.

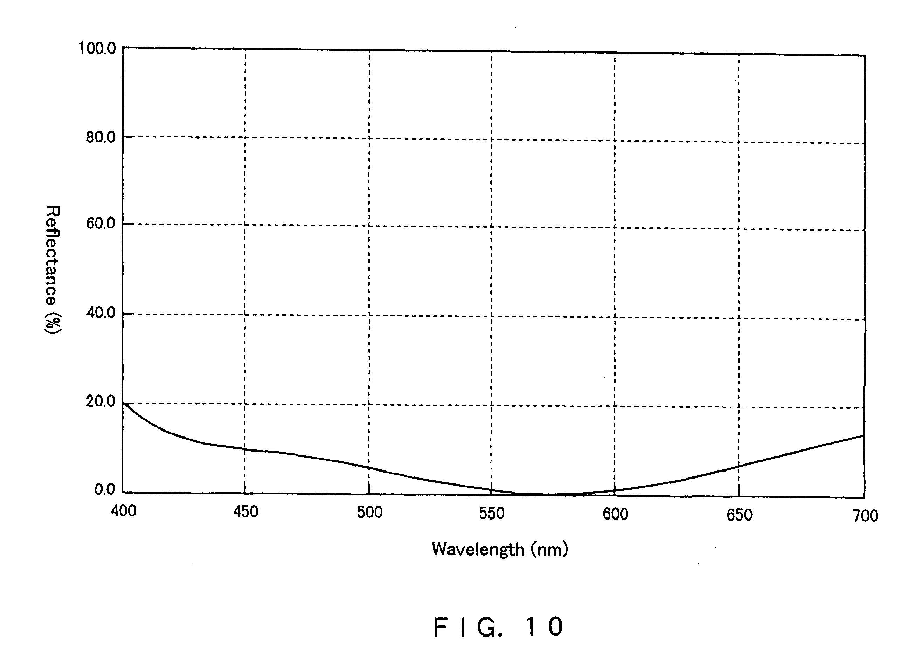

Furthermore, a solid-state imaging device was produced similarly to the above except that the anti-reflection film in the above table was changed to niobium oxide film (refractive index of 2.1) having a thickness equal to that of tantalum oxide film. The measurement of the spectral reflectance thereof achieved the same result as in FIG. 9. Moreover, a solid-state imaging device was produced similarly to the above except that the anti-reflection film in the above table was changed to titanium oxide film (refractive index of 2.3) having a thickness of 35 nm. The spectral reflectance thereof is shown in FIG. 10.

Also, in these solid-state imaging devices produced in the present example as described above, dark current and white mark defects were measured. As in the solid-state imaging device produced in the first example, it was confirmed that generation of both dark current and white mark was suppressed compared with the solid-state imaging device using the silicon nitride film.

The present invention is not limited to the above examples.

### Industrial Applicability

As described above, in accordance with the present invention, the anti-reflection film formed of oxide with a refractive index of at least 1.9 is used, thereby supplying hydrogen to the substrate sufficiently so as to reduce the dark current. Also, since the anti-reflection film has a small internal stress, it is possible to reduce the white mark defects caused by the concentrated stress. Furthermore, because there is no limitation in a shape of the anti-reflection film, it becomes possible to form the anti-reflection film on the entire surface of the substrate, thereby achieving a simpler manufacturing process and still higher sensitivity. In addition, it also is possible to obtain the anti-reflection effect that is at least equal to or larger than the conventional one. Accordingly, the present invention can improve characteristics of a solid-state imaging device.

## Claims

1. A solid-state imaging device comprising:
a semiconductor substrate;
light-receiving portions formed in the semiconductor substrate; and
an anti-reflection film formed above the light-receiving portions;
wherein the anti-reflection film is formed of an oxide having a refractive index of at least 1.9.

2. The solid-state imaging device according to claim 1, wherein the anti-reflection film is formed of the oxide of at least one metal selected from the group consisting of titanium, zirconium, tantalum, indium and niobium.

3. The solid-state imaging device according to claim 1, wherein the anti-reflection film has a thickness of at least 10 nm and not larger than 70 nm.

4. The solid-state imaging device according to claim 1, wherein the anti-reflection film has a refractive index of at least 2.1.

5. The solid-state imaging device according to claim 1 further comprising:
electrodes for transferring a charge accumulated in the light-receiving portions;
a shielding film formed above the electrodes so that an opening is provided above the light-receiving portions; and
an interlayer insulating film interposed between the electrodes and the shielding film;
wherein the interlayer insulating film is formed on the anti-reflection film above the light-receiving portions and has a lower refractive index than the anti-reflection film.

6. The solid-state imaging device according to claim 5, wherein the interlayer insulating film has a thickness of at least 30 nm and not larger than 600 nm.

7. The solid-state imaging device according to claim 5 further comprising a surface protection film formed on the interlayer insulating film, wherein the surface protection film has a higher refractive index than the interlayer insulating film.

8. The solid-state imaging device according to claim 7, wherein the surface protection film has a thickness of at least 100 nm and not larger than 300 nm.

9. The solid-state imaging device according to claim 1 further comprising a silicon oxide film that is interposed between the semiconductor substrate and the anti-reflection film.

10. The solid-state imaging device according to claim 1, wherein the anti-reflection film is formed so as to entirely cover at least a region where the light-receiving portions are formed.

11. The solid-state imaging device according to claim 10, wherein the anti-reflection film is formed so as to cover at least a part of electrodes for transferring a charge accumulated in the light-receiving portions.

12. A solid-state imaging device comprising:
a semiconductor substrate;
light-receiving portions formed in the semiconductor substrate; and
a silicon oxide film with a thickness of 50 nm or smaller, an anti-reflection film with a thickness of at least 10 nm and not larger than 70 nm, an interlayer insulating film with a thickness of at least 30 nm and not larger than 600 nm, and a surface protection film with a thickness of at least 100 nm and not larger than 300 nm laminated in this order on the light-receiving portions,
wherein the anti-reflection film is formed of an oxide having a refractive index of at least 1.9, and
the interlayer insulating film has a lower refractive index than the anti-reflection film and the surface protection film.

13. A method for manufacturing a solid-state imaging device comprising:
forming light-receiving portions in a semiconductor substrate; and
forming an anti-reflection film above the light-receiving portions;
wherein the anti-reflection film is formed of an oxide having a refractive index of at least 1.9.

## Amended claims

### Amended claims in accordance with Rule 86(2) EPC.

1. (Amended) A solid-state imaging device comprising:
a semiconductor substrate;
light-receiving portions formed in the semiconductor substrate; and
an anti-reflection film formed above the light-receiving portions;
wherein the anti-reflection film is formed of an oxide having a refractive index of at least 1.9, so as to entirely cover at least a region where the light-receiving portions are formed and to cover at least a part of electrodes for transferring a charge accumulated in the light-receiving portions.

2. The solid-state imaging device according to claim 1, wherein the anti-reflection film is formed of the oxide of at least one metal selected from the group consisting of titanium, zirconium, tantalum, indium and niobium.

3. The solid-state imaging device according to claim 1, wherein the anti-reflection film has a thickness of at least 10 nm and not larger than 70 nm.

4. The solid-state imaging device according to claim 1, wherein the anti-reflection film has a refractive index of at least 2.1.

5. The solid-state imaging device according to claim 1 further comprising:
electrodes for transferring a charge accumulated in the light-receiving portions;
a shielding film formed above the electrodes so that an opening is provided above the light-receiving portions; and
an interlayer insulating film interposed between the electrodes and the shielding film;
wherein the interlayer insulating film is formed on the anti-reflection film above the light-receiving portions and has a lower refractive index than the anti-reflection film.

6. The solid-state imaging device according to claim 5, wherein the interlayer insulating film has a thickness of at least 30 nm and not larger than 600 nm.

7. The solid-state imaging device according to claim 5 further comprising a surface protection film formed on the interlayer insulating film, wherein the surface protection film has a higher refractive index than the interlayer insulating film.

8. The solid-state imaging device according to claim 7, wherein the surface protection film has a thickness of at least 100 nm and not larger than 300 nm.

9. The solid-state imaging device according to claim 1, wherein a silicon oxide film is interposed between the semiconductor substrate and the anti-reflection film.

10. (Canceled)

11. (Canceled)

12. (Amended) A solid-state imaging device comprising:
a semiconductor substrate;
light-receiving portions formed in the semiconductor substrate; and
a silicon oxide film with a thickness of 50 nm or smaller, an anti-reflection film with a thickness of at least 10 nm and not larger than 70 nm, an interlayer insulating film with a thickness of at least 30 nm and not larger than 600 nm, and a surface protection film with a thickness of at least 100 nm and not larger than 300 nm laminated in this order on the light-receiving portions,
wherein the anti-reflection film is formed of an oxide having a refractive index of at least 1.9, so as to entirely cover at least a region where the light-receiving portions are formed and to cover at least a part of electrodes for transferring a charge accumulated in the light-receiving portions, and
the interlayer insulating film has a lower refractive index than the anti-reflection film and the surface protection film.

13. (Amended) A method for manufacturing a solid-state imaging device comprising:
forming light-receiving portions in a semiconductor substrate; and
forming an anti-reflection film above the light-receiving portions;
wherein the anti-reflection film is formed of an oxide having a refractive index of at least 1.9, so as to entirely cover at least a region where the light-receiving portions are formed and to cover at least a part of electrodes for transferring a charge accumulated in the light-receiving portions.
